# EUROPEAN PATENT APPLICATION

(11) **EP 1 199 384 A2**
(43) Date of publication of application: **24.04.2002**
(21) Application number: 01308872.9
(22) Date of filing: 19.10.2001
(51) Int. Cl.: C25D 3/38, C25D 5/48, C25D 7/12, H01L 21/321

(54) **Plating Bath**

(30) Priority: 20.10.2000 US 242349 P; 17.10.2001 US
(71) Applicant: Shipley Co. L.L.C., Marlborough, MA 01752 (US)
(72) Inventor: Merricks, David, Earlsdon, Coventry CV5 6PU (GB); Morrissey, Denis, Huntington, New York 11743 (US); Bayes, Martin W., Hopkinton, Massachusetts 01748 (US); Lefebvre, Mark, Hudson, New Hampshire 03051 (US); Shelnut, James G., Northboro, Massachusetts 01532 (US); Storjohann, Donald E., Watertown, Massachusetts 02472-3546 (US)
(74) Representative: Kent, Venetia Katherine

(57) **Abstract**

Disclosed are electroplating baths for enhancing copper seed layers and for subsequent metallization on the seed layers. Methods of enhancing copper seed layers and depositing metal on such seed layers are also disclosed.

## Description

### Background of the Invention

This invention relates generally to the field of seed layers for subsequent metallization. In particular, this invention relates to methods for repairing seed layers prior to metallization and to methods for filling of apertures.

The trend toward smaller microelectronic devices, such as those with sub-micron geometries, has resulted in devices with multiple metallization layers to handle the higher densities. One common metal used for forming metal lines, also referred to as wiring, on a semiconductor wafer is aluminum. Aluminum has the advantage of being relatively inexpensive, having low resistivity, and being relatively easy to etch. Aluminum has also been used to form interconnections in vias to connect the different metal layers. However, as the size of via/contact holes shrinks to the sub-micron region, a step coverage problem appears which in turn can cause reliability problems when using aluminum to form the interconnections between the different metal layers. Such poor step coverage results in high current density and enhances electromigration.

One approach to providing improved interconnection paths in the vias is to form completely filled plugs by using metals such as tungsten while using aluminum for the metal layers. However, tungsten processes are expensive and complicated, tungsten has high resistivity, and tungsten plugs are susceptible to voids and form poor interfaces with the wiring layers.

Copper has been proposed as a replacement material for interconnect metallizations. Copper has the advantages of improved electrical properties as compared to tungsten and better electromigration property and lower resistivity than aluminum. The drawbacks to copper are that it is more difficult to etch as compared to aluminum and tungsten and it has a tendency to migrate into the dielectric layer, such as silicon dioxide. To prevent such migration, a barrier layer, such as titanium nitride, tantalum nitride and the like, must be used prior to the depositing of a copper layer.

Typical techniques for applying a metal layer, such as electrochemical deposition, are only suitable for applying copper to an electrically conductive layer. Thus, an underlying conductive seed layer, typically a metal seed layer such as copper, is generally applied to the substrate prior to electrochemically depositing copper. Such seed layers may be applied by a variety of methods, such as physical vapor deposition ("PVD") and chemical vapor deposition ("CVD"). Typically, seed layers are thin in comparison to other metal layers, such as from 50 to 1500 angstroms thick.

US Patent No. 5,824,599 (Schacham-Diamand et al.) discloses a method of preventing oxide formation on the surface of a copper seed layer by conformally blanket depositing under vacuum a catalytic copper layer over a barrier layer on a wafer and then, without breaking the vacuum, depositing a protective aluminum layer over the catalytic copper layer. Such blanket deposition of a copper layer under vacuum is typical of such procedures used commercially.

PCT patent application number WO 99/47731 (Chen) discloses a method of providing a seed layer by first vapor depositing an ultra-thin seed layer followed by electrochemically enhancing the ultra-thin seed layer to form final a seed layer. The copper seed layer is enhanced by using an alkaline electrolytic bath., i.e. discontinuities, i.e. areas in the seed layer where coverage of the seed layer is incomplete or lacking, are reduced. Such alkaline plating is conformal. Bottom-up fill of apertures, particularly very small apertures, is not disclosed. Subsequent metal fill of apertures is preferably accomplished by electroplating with an acid copper bath. However, one using this method to enhance a seed layer would have to rinse and neutralize the seed layer before using conventional acidic electrolytic plating baths. Only alkaline copper plating baths containing copper sulfate are disclosed in this patent application.

International Patent Application WO 01/24239 (Tench et al.) discloses highly complexed copper plating solutions for the electroplating of copper circuitry in trenches and vias in the Damascene process of integrated circuit manufacture. The highly complexing anions for copper include pyrophosphate, cyanide and sulfamate. This patent application discloses the complete fill of features such as vias and trenches, i.e. circuitry formation. This patent application fails to disclose copper pyrophosphate plating solutions in the deposition of a copper seed layer for subsequent plating of copper circuitry.

Thus, there is a continuing need for methods of repairing seed layers having oxidation and discontinuities, particularly for use in devices having small geometries, such as 0.5 micron and below. Further, there is also a need for bottom-up filling of apertures.

### Summary of the Invention

It has been surprisingly found that the present alkaline electroplating solutions may be used to repair copper seed layer by providing seed layers substantially free of discontinuities prior to subsequent metallization. It has further been found that the present alkaline copper plating baths provide bottom-up fill of apertures.

In one aspect, the present invention provides a method of providing a metal seed layer substantially free of discontinuities disposed on a substrate including the steps of contacting a metal seed layer disposed on a substrate with an alkaline copper electroplating bath including copper pyrophosphate.

In a second aspect, the present invention provides a method of manufacturing an electronic device including the step of contacting a metal seed layer disposed on a substrate with an alkaline copper electroplating bath including copper pyrophosphate.

In a third aspect, the present invention provides an article of manufacture including an electronic device substrate containing one or more apertures, each aperture containing a seed layer deposit enhanced by contact with an alkaline electroplating composition that includes copper pyrophosphate.

In a fourth aspect, the present invention provides a method for removing excess material from a semiconductor wafer containing one or more apertures by using a chemical mechanical planarization process which includes contacting the semiconductor wafer with a rotating polishing pad thereby removing the excess material from the semiconductor wafer; wherein the apertures contain a seed layer deposit enhanced by contact with an alkaline electroplating composition that includes copper pyrophosphate.

In a fifth aspect, the present invention provides a method for removing excess material from a semiconductor wafer containing one or more apertures by using a chemical mechanical planarization process which includes contacting the semiconductor wafer with a rotating polishing pad thereby removing the excess material from the semiconductor wafer; wherein the apertures contain a copper deposit obtained by contact with an alkaline electroplating composition that includes copper pyrophosphate.

In a sixth aspect, the present invention provides a method of enhancing a copper seed layer including the steps of: contacting a seed layer disposed on a substrate with an alkaline electroplating composition including copper pyrophosphate and subjecting the electroplating composition to a current density sufficient to provide a seed layer substantially free of discontinuities.

### Detailed Description of the Invention

As used throughout the specification, the following abbreviations shall have the following meanings, unless the context clearly indicates otherwise: nm = nanometers; g/L = grams per liter; oz/g = ounces per U.S. gallon; µm = micron = micrometer; ASF = amperes per square foot; M = molar; mA/cm² = milliamperes per square centimeter; ° C = degrees Centigrade; ° F = degrees Fahrenheit; and ppm = parts per million.

As used throughout the specification, "feature" refers to the geometries on a substrate, such as, but not limited to, trenches and vias. "Apertures" refer to recessed features, such as vias and trenches. The term "small features" refers to features that are one micron or smaller in size. "Very small features" refers to features that are one-half micron or smaller in size. Likewise, "small apertures" refer to apertures that are one micron or smaller in size and "very small apertures" refer to apertures that are one-half micron or smaller in size. As used throughout this specification, the term "plating" refers to metal electroplating, unless the context clearly indicates otherwise. "Deposition" and "plating" are used interchangeably throughout this specification. The term "accelerator" refers to a compound that enhances the plating rate. The term "suppressor" refers to a compound that suppresses the plating rate. "Halide" refers to fluoride, chloride, bromide, and iodide.

All percentages and ratios are by weight unless otherwise indicated. All ranges are inclusive and combinable.

The present invention provides certain alkaline copper electroplating baths that are capable of providing seed layers, particularly copper or copper alloy seed layers, that are substantially free of discontinuities or voids. The present electroplating baths are particularly suitable for use in the manufacture of electronic devices, and particularly in the manufacture of integrated circuits.

Electroplating solutions of the present invention generally include copper pyrophosphate, one or more complexing agents, water, and orthophosphate. The electroplating solutions of the present invention may optionally contain one or more additives, such as halides, accelerators or brighteners, suppressors, levelers, grain refiners, wetting agents, surfactants and the like.

Copper pyrophosphate is present in the electroplating baths in an amount of from about 2.5 oz/g to about 4 oz/gal. Amounts above and below this range may be used but with less desirable copper deposits.

The seed layer repairing electroplating baths may also contain amounts of other alloying elements. Thus, the copper electroplating baths useful in the present invention may deposit copper or copper alloy.

The pH of the present alkaline electroplating baths is typically in the range of from >7 to 11, preferably 7.5 to 9, more preferably 8 to 9, still more preferably 8 to 8.8, and even more preferably 8.1 to 8.5. It is preferred that the pH is ≤9 as baths having a pH >9 tend to cause roughness and a decrease in current density. Baths having a pH <7 tend to cause orthophosphate buildup and a loss of throwing power. Suitable complexing agents include pyrophosphate salts such as potassium pyrophosphate and sodium pyrophosphate. Typically, the pyrophosphate to copper ratio is in the range of from 5:1 to 9.5:1, preferably 6:1 to 9.5:1, more preferably 7:1 to 9:1 and even more preferably 7.5:1 to 8:1.

One or more bases may optionally be added to the present electroplating baths. Suitable optional bases include, but are not limited to, ammonium hydroxide and tetra(C₁-C₄)alkylammonium hydroxides such as tetramethylammonium hydroxide. The amount of bases may be from 0.05 to 0.5 oz/gal, and preferably from 0.1 to 0.4 oz/g.

Particularly suitable electroplating baths according to the present invention are those that are substantially free of ammonia, alkali metal or both. In an alternate embodiment, the present copper pyrophosphate plating baths are free of ammonia or alkali metal and more preferably free of both ammonia and alkali metal.

The present electrolytes may optionally contain one or more halides, and preferably do contain at least one halide. Chloride and bromide are preferred halides, with chloride being more preferred. A wide range of halide ion concentrations (if a halide ion is employed) may be suitably utilized, e.g. from about 0 (where no halide ion employed) to 40 ppm of halide ion in the plating solution. Such halides may be added as the corresponding hydrogen halide acid or as any suitable salt.

A wide variety of brighteners or accelerators, including known brightener agents, may be employed in the present compositions. Particularly suitable brighteners are mercaptobenzothiazole, such as 2-potassium mercaptobenzothiazole, and 2,5-dimercapto-1,3,4-thiadiazole. Such brighteners may be used alone or in combination. The amount of brighteners or accelerators present in the electroplating baths is in the range of from about 0.1 to about 1000 ppm. Preferably, such compounds are present in an amount of from about 0.5 to about 300 ppm, more preferably from about 1 to about 100 ppm, and still more preferably from about 2 to about 50 ppm.

Other suitable organic additives that can be added to the present electroplating baths include one or more suppressors, one or more levelers, one or more surfactants, one or more grain refiners and the like. The amount of such suppressors present in the electroplating baths is in the range of from about 0.1 to about 1000 ppm. Preferably, the suppressor compounds are present in an amount of from about 0.5 to about 500 ppm, and more preferably from about 1 to about 200 ppm. Surfactants are typically added to copper electroplating solutions in concentrations ranging from about 1 to 10,000 ppm based on the weight of the bath, more preferably about 5 to 10,000 ppm. Particularly suitable surfactants for plating compositions of the invention are commercially available polyethylene glycol copolymers, including polyethylene glycol copolymers. Such polymers are available from e.g. BASF (sold by BASF under TETRONIC and PLURONIC tradenames), and copolymers from Chemax. Levelers may optionally be added to the present electroplating baths in amounts of from about 0.01 to about 50 ppm.

Electroplating baths of the present invention are advantageously used to treat or repair copper or copper alloy seed layers to provide seed layers substantially free of discontinuities. It is preferred that the present invention provides a seed layer substantially free of discontinuities and substantially free of seed layer oxidation.

The present copper electroplating compositions are suitably used in similar manner as conventional more concentrated copper electroplating baths. Plating baths of the invention are preferably employed at a wide range of temperatures from below room temperature to above room temperature, e.g. up to 65° F and greater. Preferably, the plating baths are operated at a temperature in the range of from 100 to 135° F, and preferably from 115° to 125° F. The plating composition is preferably agitated during use such as by air sparger, work piece agitation, impingement or other suitable method. Plating is preferably conducted at a current ranging from 1 to 40 ASF depending upon substrate characteristics, and preferably 20 to 35 ASF. Plating time may range from about 2 minutes to 1 hour or more, depending on the difficulty of the work piece.

A wide variety of substrates may be plated with the compositions of the invention, as discussed above. The compositions of the invention are particularly useful to plate difficult work pieces, such as circuit board substrates with small diameter, high aspect ratio microvias and other apertures. The plating compositions of the invention also will be particularly useful for plating integrated circuit devices, such as formed semiconductor devices and the like. The compositions of the invention are particularly suitable for plating high aspect ratio microvias and trenches, such as those having aspect rations of 4:1 or greater.

As discussed above, aspect ratios of at least 4:1, having diameters of about 200 nm or smaller have been effectively copper plated with no defects (e.g. no voids or inclusions by ion beam examination) using plating solutions of the invention. Apertures with diameters below 150 nm, or even below about 100 nm, and aspect ratios of 5:1, 6:1, 7:1, 10:1 or greater, and even up to about 15:1 or greater can be effectively plated (e.g. no voids or inclusions by ion beam examination) using plating solutions of the invention. The present invention is particularly suitable for repairing seed layers on substrates having 1 µm and smaller apertures, preferably 0.5 µm and smaller apertures, and more preferably 0.18 µm and smaller apertures.

A wide variety of substrates may be plated with copper according to the present invention. Particularly suitable are substrates used in the manufacture of electronic devices, such as wafers used in the manufacture of integrated circuits, printed wiring board inner layers and outer layers, flexible circuits and the like. It is preferred that the substrate is a wafer.

Thus, the present invention provides a method of providing a metal seed layer substantially free of discontinuities disposed on a substrate comprising the steps of contacting a metal seed layer disposed on a substrate with an alkaline electroplating bath including copper pyrophosphate. The seed layer-containing substrate is then subjected to a current density in the range of 1 to 40 ASF for a period of time sufficient to enhance the seed layer, i.e. substantially remove or repair the discontinuities to provide a seed layer substantially free of discontinuities.

The present invention also provides a method of manufacturing an electronic device comprising the step of contacting a metal seed layer disposed on a substrate with an alkaline copper electroplating bath comprising copper pyrophosphate. An advantage of the present invention is that not only is the seed layer enhanced by substantially removing discontinuities, but the present electroplating bath can also be used to substantially metallize or fill the apertures with copper. The present electroplating bath, thus, also provides bottom-up fill or superfill.

"Superfill" or bottom-up fill occurs when metal plating at the bottom of features, particularly small features, is faster than plating occurring on the top surface of the substrate to be plated. "Conformal plating" occurs when metal plating following the surface topography is occurs at the same rate as metal plating in the bottom of features, such as trenches or vias. At times, conformal plating is desired, while at other times superfill plating is desired. In the manufacture of certain electronic devices, such as wafers used in the manufacture of integrated circuits or semiconductors having small or very small features, superfill plating is desired. Particularly desired is superfill copper electroplating in such electronic device manufacture.

In general, superfill deposition occurs when the deposition rate at the bottom of the features is greater than the deposition rate at the top surface of the substrate. While not intending to be bound by theory, it is believed that the deposition rate at the surface of the substrate is controlled by mass transport (convection) of the reactants in the plating bath and the magnitude of the current applied. It is further believed, while not intending to be bound by theory, that convection inside the features is unimportant when plating very small features and that the deposition rate inside the features is controlled by mass transport (diffusion).

Accordingly, the present invention also provides an article of manufacture including an electronic device substrate containing one or more apertures, each aperture containing a seed layer deposit enhanced by contact with an alkaline electroplating composition that comprises copper pyrophosphate. The present invention further provides an article of manufacture including an electronic device substrate containing one or more apertures, each aperture containing a seed layer deposited by contact with an alkaline electroplating composition that comprises copper pyrophosphate.

In an alternative embodiment, the substrate having an enhanced seed layer may be removed from the plating bath, rinsed with water and contacted with a second copper electroplating bath to metallize or fill the apertures. Such second electroplating bath may be alkaline or acidic. Such plating baths are well known to those skilled in the art. After metallization, i.e. filling of the apertures, the substrate, in the case of a wafer, is preferably subjected to chemical-mechanical planarization ("CMP"). A CMP procedure can be conducted in accordance with the invention as follows.

The wafer is mounted in a wafer carrier which urges the wafer against the surface of a moving polishing pad. The polishing pad can be a conventional smooth polishing pad or a grooved polishing pad. Examples of a grooved polishing pad are described in United States Patent Nos. 5,177,908; 5,020,283; 5,297,364; 5,216,843; 5,329,734; 5,435,772; 5,394,655; 5,650,039; 5,489,233; 5,578,362; 5,900,164; 5,609,719; 5,628,862; 5,769,699; 5,690,540; 5,778,481; 5,645,469; 5,725,420; 5,842,910; 5,873,772; 5,921,855; 5,888,121; 5,984,769; and European Patent 806267. The polishing pad can be located on a conventional platen can rotate the polishing pad. The polishing pad can be held on the platen by a holding means such as, but not limited to, an adhesive, such as, two faced tape having adhesive on both sides.

A polishing solution or slurry is fed onto the polishing pad. The wafer carrier can be at a different positions on the polishing pad. The wafer can be held in position by any suitable holding means such as, but is not limited to, a wafer holder, vacuum or liquid tensioning such as, but not limited to a fluid such as, but not limited to water. If the holding means is by vacuum then there is preferably a hollow shaft which is connected to the wafer carrier. Additionally, the hollow shaft could be used to regulate gas pressure, such as, but not limited to air or an inert gas or use a vacuum to initially hold the wafer. The gas or vacuum would flow from the hollow shaft to the carrier. The gas can urge the wafer against the polishing pad for the desired contour. The vacuum can initially hold the wafer into position in the wafer carrier. Once the wafer is located on top of the polishing pad the vacuum can be disengaged and the gas pressure can be engaged to thrust the wafer against the polishing pad. The excess or unwanted copper is then removed. The platen and wafer carrier can be independently rotatable. Therefore, it is possible to rotate the wafer in the same direction as the polishing pad at the same or different speed or rotate the wafer in the opposite direction as the polishing pad.

Thus, the present invention provides a method for removing excess material from a semiconductor wafer containing one or more apertures by using a chemical mechanical planarization process which includes contacting the semiconductor wafer with a rotating polishing pad thereby removing the excess material from the semiconductor wafer; wherein the apertures contain a seed layer deposit enhanced by contact with an alkaline electroplating composition that includes copper pyrophosphate.

Also provided is a method for removing excess material from a semiconductor wafer containing one or more apertures by using a chemical mechanical planarization process which includes contacting the semiconductor wafer with a rotating polishing pad thereby removing the excess material from the semiconductor wafer; wherein the apertures contain a copper deposit obtained by contact with an alkaline electroplating composition that includes copper pyrophosphate.

### Example 1

A seed layer repair bath is prepared containing copper pyrophosphate at a concentration that gives 20 g/L copper metal and also containing 140 g/L potassium pyrophosphate, ammonia at a concentration which gives a pH of 8.5 and <1 g/L organic additives (such as 2,5-dimercapto-1,3,4-thiadiazole as brightener) in water. A silicon wafer substrate having aspect ratio features of >4:1 and vias of diameter <0.15 µm covered with a copper seed layer (deposited by ion metal plasma physical vapor deposition ("IMP-PVD")) having a thickness of <100 nm over the surface is contacted with the seed layer repair bath at 45° C. A current density of 3 mA/cm² is then applied to the bath for three minutes. Following this, the substrate is removed from the seed layer repair bath, rinsed with de-ionized water and dried in a spin-rinse-dry module. The wafer substrate is then metallized by subjecting the substrate to an electrolytic copper plating bath such as that sold by Shipley Company (Marlborough, Massachusetts) under the ULTRAFILL 2001 trademark. The wafer substrate is placed in the bath for a sufficient period of time to provide the desired copper layer. The wafer substrate is then removed from the electrolytic plating bath, rinsed with de-ionized water and subjected to further processing.

### Example 2

A seed layer repair bath is prepared containing 90 g/L copper pyrophosphate, 220 g/L ammonium pyrophosphate, 55 g/L ammonium phosphate, tetramethylmmonium hydroxide at a concentration that gives a pH of 8.5 and <1 g/L organic additives (such as 2,5-dimercapto-1,3,4-thiadiazole as brioghtener) in water. A silicon wafer substrate having aspect ratio features of >4:1 and vias of diameter <0.15 µm covered with a copper seed layer (deposited by IMP- PVD) having a thickness of <100 nm over the surface is contacted with the seed layer repair bath at 45° C. A current density of 2 mA/cm² is then applied to the bath for eight minutes. Following this, the substrate is removed from the seed layer repair bath, rinsed with de-ionized water and dried in a spin-rinse-dry module. The wafer substrate is then metallized by subjecting the substrate to an electrolytic copper plating bath, such as that sold by Shipley Company (Marlborough, Massachusetts) under the ULTRAFILL 2001 trademark. The wafer substrate is placed in the bath for a sufficient period of time to provide the desired copper layer. The wafer substrate is then removed from the electrolytic plating bath, rinsed with de-ionized water and subjected to further processing.

## Claims

1. A method of providing a metal seed layer substantially free of discontinuities disposed on a substrate comprising the step of contacting a metal seed layer disposed on a substrate with an alkaline copper electroplating bath comprising copper pyrophosphate.

2. A method as claimed in claim 1 wherein the electroplating bath has a pH of from 8 to 9.

3. A method as claimed in claim 1 or claim 2, wherein the electroplating bath further comprises a complexing agent.

4. A method as claimed in any one of the preceding claims, wherein the electroplating bath further comprises one or more bases selected from ammonium hydroxide or tetra(C₁-C₄)alkylammonium hydroxide.

5. A method as claimed in any one of the preceding claims, wherein the electroplating bath further comprises one or more compounds selected from halides, brighteners, suppressors, levelers, grain refiners, wetting agents or surfactants.

6. A method as claimed in any one of the preceding claims, wherein the electroplating bath further comprises one or more brightener compounds in an amount of ≥ 1.5 mg/L.

7. A method of manufacturing an electronic device comprising the step of providing a metal seed layer prepared in accordance with a method as claimed in any one of the preceding claims.

8. An article of manufacture comprising an electronic device substrate containing one or more apertures, each aperture containing a metal seed layer prepared according to a method as claimed in any one of claims 1 to 6.

9. A method for removing excess material from a semiconductor wafer containing one or more apertures by using a chemical mechanical planarization process which comprises contacting the semiconductor wafer with a rotating polishing pad thereby removing the excess material from the semiconductor wafer; wherein the apertures contain a metal seed layer prepared according to a method as claimed in any one of claims 1 to 6.

10. A method for removing excess material from a semiconductor wafer containing one or more apertures by using a chemical mechanical planarization process which comprises contacting the semiconductor wafer with a rotating polishing pad thereby removing the excess material from the semiconductor wafer; wherein the apertures contain a copper deposit obtained by contact with an alkaline electroplating bath as defined in any one of claims 1 to 6.
